# EUROPEAN PATENT SPECIFICATION

(11) **EP 1 645 114 B1**
(45) Date of publication and mention of the grant of the patent: **06.06.2007**
(21) Application number: 03817448.8
(22) Date of filing: 11.07.2003
(51) Int. Cl.: H04N 5/44

(54) **INTEGRATED CIRCUIT FOR A MOBILE TELEVISION RECEIVER**
INTEGRIERTE SCHALTUNG FÜR EINEN MOBILEN FERNSEHEMPFÄNGER
CIRCUIT INTEGRE POUR RECEPTEUR DE TELEVISION MOBILE

(43) Date of publication of application: 12.04.2006
(73) Proprietor: Infineon Technologies AG, 81669 München (DE)
(72) Inventor: LOW, Hwang, Chee, Singapore 440071 (SG); NEO, Tee, Yong, Singapore 530542 (SG); Muschallik, Claus, 82024 Taufkirchen (DE)
(74) Representative: Howe, Steven
(86) International application number: PCT/SG2003/000167
(87) International publication number: WO 2005/006743

(56) References cited:
- EP-A- 1 246 458
- DE-A- 10 009 284
- US-B1- 6 487 391
- KUCHEN F ET AL: "Terrestrial network planning for digital video broadcasting to mobile receivers" VEHICULAR TECHNOLOGY CONFERENCE, 1998. VTC 98. 48TH IEEE OTTAWA, ONT., CANADA 18-21 MAY 1998, NEW YORK, NY, USA,IEEE, US, 18 May 1998 (1998-05-18), pages 1889-1893, XP010288145 ISBN: 0-7803-4320-4

## Description

### Field of the invention

The present invention relates to an integrated circuit for use in a mobile television receiver.

### Background of invention

There is a continuing desire to develop standards for mobile television, that is techniques for transmission of radio frequency TV signals for reception by mobile receivers arranged to decode them and display the TV images and audio obtained from them.

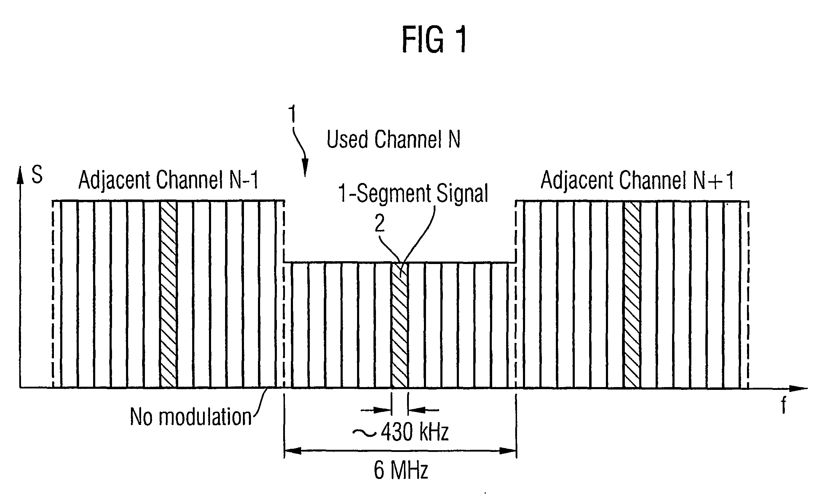

Various standards for mobile TV are presently under development. A first standard, the so called "1-segment standard", which is under development in Japan, is illustrated in Fig. 1. In this standard, a number of channels (each representing a respective TV channel) are transmitted in respective consecutive frequency ranges, each having a width of, say, 6 MHz. A typical central value of a centre frequency range may be about 800 MHz. Fig. 1 shows the signal strength (S) at various frequencies (f) for three such channels, numbered N-1, N and N+1. Within each frequency range are defined a respective set of 13 segments, of width around 430 kHz (the frequency ranges for different channels are spaced apart by a frequency range of about 410 kHz). The TV signal is transmitted by broadcasting data on a single frequency on each of the segments: thus 13 signals are simultaneously broadcast. Conventional TV receivers receive the signals on all 13 of the channels and use them to obtain a high-resolution TV output. However, a mobile receiver receives only one of the 13 signals (specifically, a signal within the segment which is at the centre of the 13 segment), and decodes it to obtain TV output with a low resolution. The 13 segments of the N-th channel are labelled on Fig. 1 by reference numeral 1, and mobile TV data is on the segment labelled 2.

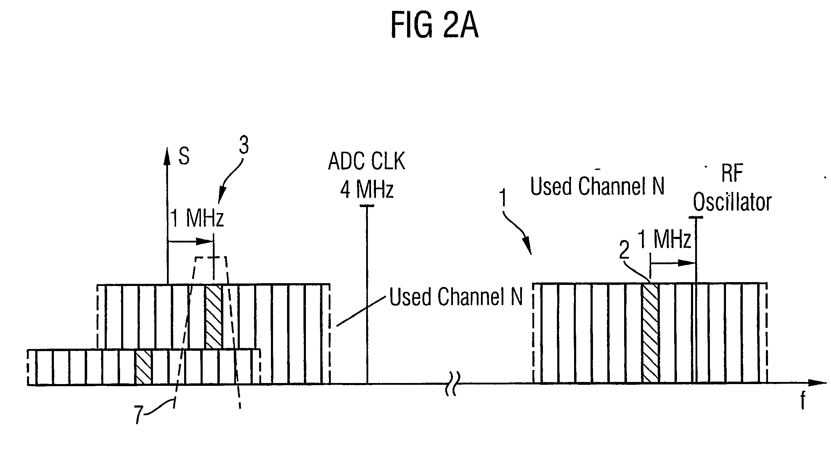

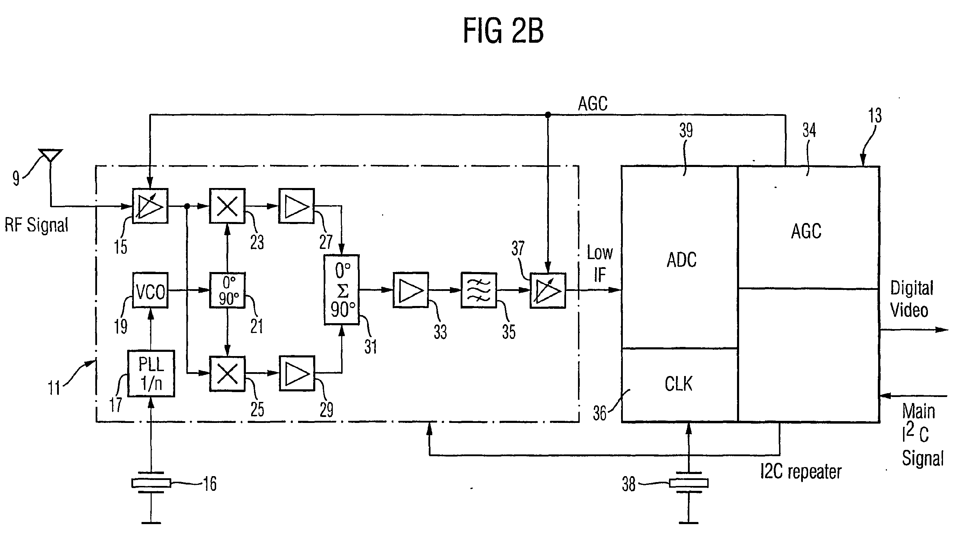

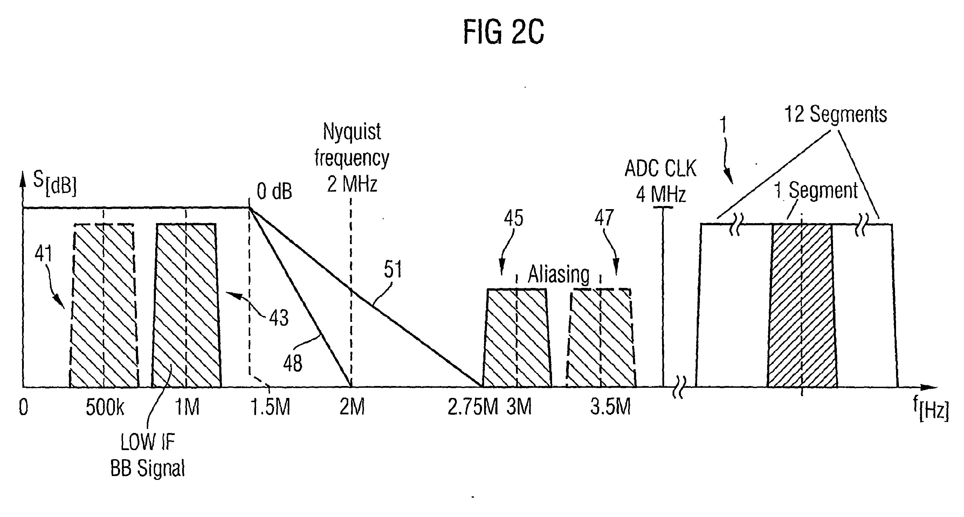

Fig. 2(a) shows steps in processing this signal. The thirteen segments of the channel (indicated collectively by reference numeral 1) are mixed with an RF oscillator signal. This converts the signal to a low intermediate frequency (IF) signal indicated as 3, also containing 13 segments. The conversion also produces an image of the channel N, which is indicated as 5. The IF signal is sampled with a clock having a frequency of e.g. 4 MHz. The mobile receiver can extract from this signal the segment which contains the information for the mobile TV using a filter 7 centred at 1 MHz. Using an image rejection structure as shown in Fig. 2(b), the image signal 5 which falls into the pass-range of the filter 7 should be removed.

The block diagram for performing this technique is illustrated in Fig. 2(b). The RF signal is received at an antenna 9, and from there input to an analogue processing unit 11 (radio-frequency integrated circuit), followed by a digital processing unit 13 (base band demodulator integrated circuit). Within the analogue processing unit 11, the RF signal is passed through a variable amplifier 15 (which, as explained below, is used to normalise the signal, based on an AGC (automatic gain control) signal). The analogue unit 11 generates also an oscillating signal from a crystal 16, which is used by a phase locked loop 17 in order to control a voltage controlled oscillator (VCO) 19. The output of the VCO unit 19 is passed to a unit 21 which transmits it to a first multiplier 23 and, with a 90 degree phase difference, to a second multiplier 25. The multipliers 23, 25 multiply the output of the amplifier 15 by their respective inputs from the unit 21. The results are amplified by respective amplifiers 27, 29, and the results are summed by an unit 31 which inserts another 90 degree phase shift between its inputs. This causes the removal of the image 5. The analogue processing unit 11 receives an I²C signal relayed by an I²C repeater from the digital processing unit 13, which in turn received it as an I²C signal from a main controller of the mobile TV apparatus.

The output of the unit 31 is passed successively through an amplifier 33, a variable filter 35, and another variable amplifier 37 which also receives the AGC signal. The result is the low IF signal. The low IF signal is passed to the digital processing unit 13, which converts it to a digital video signal using a analogue-digital converter (ADC) 39. The digital processing unit 13 further produces an AGC signal from an automatic gain control unit 34, which is fed back to control the variable amplifier 15 and 37. The digital processing unit 13 further contains a clock 36, coupled to an external crystal 38. An 12C repeater feeds back an I²C tuner signal from the digital processing unit 13 to the analogue processing unit 11. The output of the ADC 39 is decoded by other portions of the digital processing unit (base-band IC) 13, to produce the digital video signal, which is output to the right of the figure (e.g. to an MPEG 2 decoder).

The processing technique performed by the units 33, 35, 37 and 39 is illustrated in Fig. 2(c). The RF frequency range for the channel 1 from which the image has been removed, is converted down using an clock signal at 4 MHz to give a signal a low IF frequency band which, in different variants, are centred around 500kHz or 1MHz. These two possible low IF base-band signals are shown as 41 or 43. Additionally, it generates an alias signal 45 or 47. The result is processed using a base-band low pass filter 35, which performs filter function 48 or filter function 51, and thereby removes the alias component 45 and 47, to leave only the component 41 or 43, which is forwarded from the analogue processing unit 11 to the digital processing unit 13.

An alternative to the "1 segment standard" is another mobile TV transmission standard presently under development which uses all 13 of the segments of the channel 1 to transmit data which is to be used by the mobile receiver. In this standard, time may or may not be considered as divided into time intervals, such as intervals 1 ms long. In the case of TDMA (time division multiple access) during one of these intervals, mobile TV data for one channel is broadcast on all 13 of the segments of the range 1. Then, for a predetermined number of intervals, no information about the channel is broadcast. This pattern is repeated indefinitely: information on multiple frequencies is broadcast for a time interval, followed by a period of quiescence. Optionally, information about other channels is broadcast during these periods of quiescence. For example, during each of N time intervals information may be broadcast a respective one of N channels.

In this case, in certain time intervals the mobile device must receive and decode information from all the segments, so the mobile receiver must receive a much wider bandwidth. The device may perform an I/Q demodulation instead of a low IF demodulation. Optionally, this may use a frequency offset.

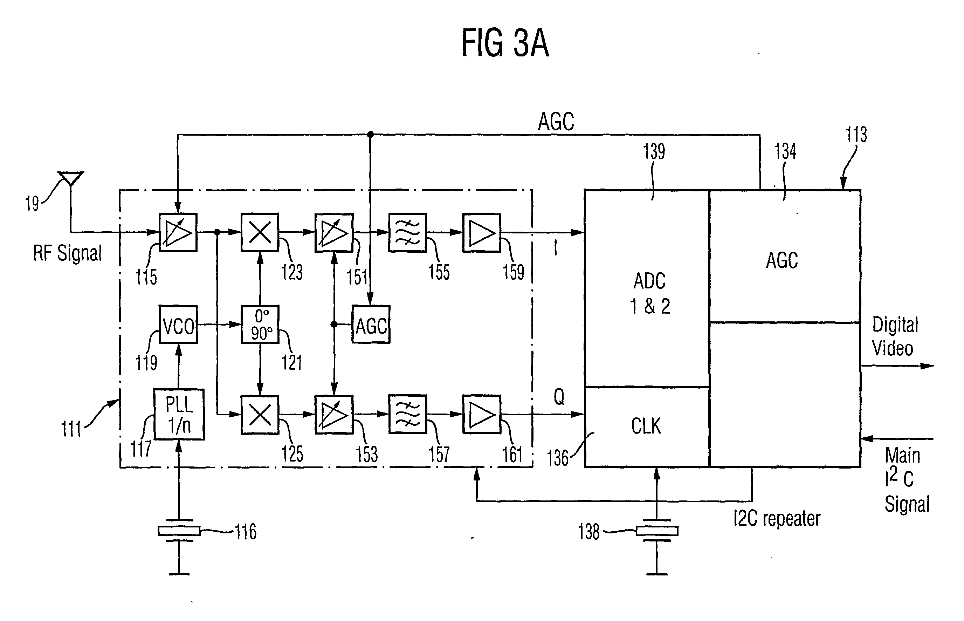

The signal processor which performs this process is shown in Fig. 3(a). Items corresponding to those of Fig. 2(b) are shown by reference numerals 100 higher. The units 31, 33, 35, 37 are replaced by two variable amplifiers 151, 153 which are controlled by the AGC signal. The outputs of the amplifiers 151, 153 are passed to the variable filters 155, 157, and from there to the amplifiers 159, 161. The result is respective I and Q signals, which are passed to the digital processing unit (base band integrated circuit) 113, which in this case has two analogue to digital converters 139 in place of the one ADC 39 of Fig. 2(b).

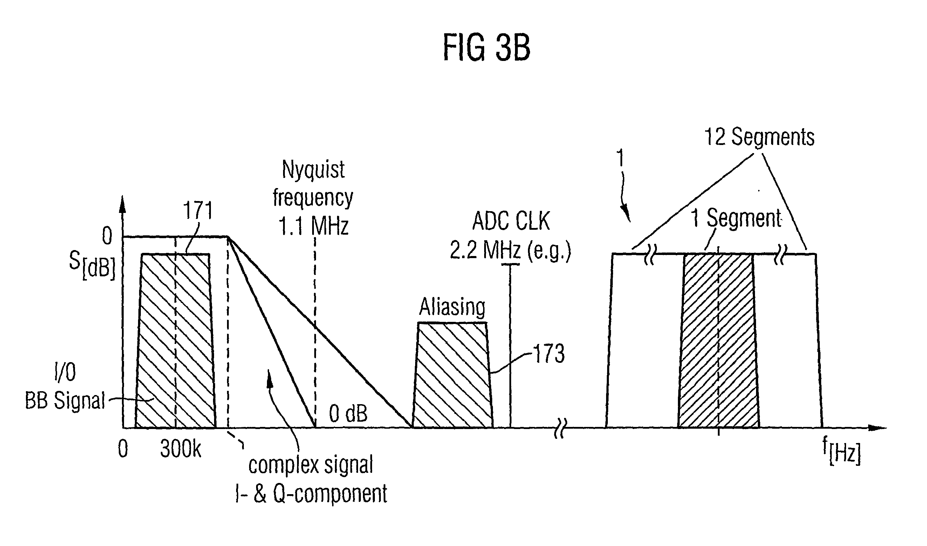

This processing technique performed by the units 151, 153, 155, 157, 159, 162 and 139 is illustrated in Fig. 3(b). Here the signal strength is written as S because it is a complex, having a real component I and imaginary component Q. The output of the units 159, 161 includes an I/Q base-band signal 171 and an alias component 173. The alias component 173 is removed by the filters 155, 157.

Note that in each of the systems shown in Fig. 2 and Fig. 3, gain control is performed using a signal AGC unit 34, 134, which is a portion of the digital processing unit 113.

### Summary of the Invention

The present invention aims to provide a new and useful integrated circuit for use in a device for receiving a mobile TV signal.

The invention also aims to provide a new and useful mobile TV reception device.

In general terms, the present invention proposes that an integrated circuit is provided which contains one or more signal paths (referred to here as input stages) for receiving one or more RF signals including a mobile TV signal from an antenna, and switching means for receiving the RF signal in parallel from the one or more input stages and transmit it selectively either to processing means which process it according to a low IF demodulation technique or to processing means which process it according to a I/Q demodulation technique.

Thus, the present invention makes it possible for the integrated circuit to decode either of the two classes of standards which are presently under investigation. Thus, the integrated circuit may be employed as a part of a mobile device which can be used in different geographical locations where different standards are in use, switching the demodulation path appropriately. This gives the mobile receiver which uses the integrated circuit great flexibility.

Specifically, a first expression of the invention is an integrated circuit for use in a mobile TV receiver, the integrated circuit having:
one or more input stages for receiving respective RF signals, including mobile TV signals,
a first signal processing path for performing low IF demodulation of the RF signals,
a second signal processing path for performing I/Q demodulation of the RF signals,
a control unit for selectively connecting the one or more input stages to the first signal processing path or to the second signal processing path, and
output means connected to the first and second signal processing paths,
whereby the control unit is arranged to determine whether the output means outputs signals which have been obtained from the one or more RF signals by IF demodulation or alternatively by I/Q demodulation.

The integrated circuit may operate in combination with a base-band demodulator which receives the output of the output means. The base-band demodulator may be according to the known designs mentioned above, which drives display means, such as an MPEG 2 decoder which delivers the video/audio data contained in the signal.

The circuitry of the integrated circuit is designed so that as many as possible of the components are used on both of the two processing paths, so that the total number of components is kept low.

The integrated circuit is preferably designed to minimise its power consumption, since this is of great importance for a mobile device which normally has only a limited power supply. For this reason, the integrated circuit preferably contains a control circuit for controlling the circuit to minimise power consumption.

The control unit may do this, for example, by disabling at least one section of the integrated circuit when it is not required, to reduce the power consumption of that section. The section in question may be the first and/or second processing paths, and/or one or more of the input stages.

Preferably, the control disables the section by setting a pin connected to the section to ground, which provides a very effective power reduction. The control unit may further reduce power consumption by turning off a circuit for delivering power to the section.

One possibility, in the case of mobile TV signals according to a standard (such the one described above) which only transmits data at intervals, is for the control unit to include a clock, and to turn one or more sections of the integrated circuit off when the clock indicates that no data is being transmitted.

Another way in which the control unit can reduce the power requirements of the mobile device is by modifying the operation of components of the integrated circuits between two operation states in which (i) they operate with high quality (i.e. high linearity of the circuit stages but high power consumption), and (ii) they operate with reduced quality but with reduced power consumption. The control unit may select the first mode of operation, for example, when the mobile device is connected to an external power supply, or when the power reserves within the mobile device are determined to be relatively great, and the second mode of operation otherwise.

Another way for the integrated circuit to reduce its power requirements is to employ two automatic gain control circuits, a first ("broadband") automatic gain control circuit operative to control the gain of the input stages, and a second ("narrowband") automatic gain control circuit operative to control the output of the output means.

The integrated circuit preferably includes a phase-lock loop unit which contributes to the processing of the RF signals. The phase-lock loop may be controlled based on oscillating signals input to the device, or alternatively ones generated using components within the integrated circuit. In this latter case, the oscillating signal is preferably transmitted out of the integrated circuit, so that it can be employed in other components of the device, such as the base band demodulator. The frequency generated may be in the range 1 to 60 MHz, preferably at least 16 MHz.

A second expression of the invention is a mobile TV receiver device including the integrated circuit, and also one or more antennas which receive one or more RF signals for input to the integrated circuit, and a processing unit which processes the output of the integrated circuit to obtain a digital video output signal.

Various possibilities exist for the antenna(s).

There may for example be a plurality of antennas receiving respective RF signals and transmitting them to respective ones of the input stages. This permits the receiver to act as a multiple-input-multiple-output device.

Alternatively or additionally, the mobile device may partition the RF signals into multiple frequency bands, sending each band signal to different respective ones of the input stages, so that those input stages can be optimised for each frequency band.

Alternatively or additionally, the antenna(s) may receive multiple radio signals with different respective polarizations, and transmit the received radio signals to different respective input stages.

It is envisaged that the mobile device will be a device such as a mobile telephone which also transmits RF signals on one or more frequencies (possibly using the same antenna(s)). Thus, the received RF signals will almost certainly contain components at these frequencies which have nothing to do with the mobile TV signals. For that reason, the receiver device may include filters for filtering out the these frequencies. The filters may be provided within the integrated circuit, arid/or as separate elements between the antennas and the integrated circuit.

### Brief Description of The Figures

Preferred features of the invention will now be described, for the sake of illustration only, with reference to the following figures in which:
Fig. 1 shows schematically signal amplitudes at different frequencies when broadcasting three channels according to a known transmission standard;
Fig. 2 is composed of Figs. 2(a), 2(b) and 2(c), which respectively show the frequency spectrum of a low IF signal, a known structure for producing this low IF signal, and a further operation produced by the structure;
Fig. 3 is composed of Figs. 3(a) and 3(b), which respectively show a block diagram of a known structure for extracting digital video from an RF signal by I/Q demodulation, and a process carried out by the structure;
Fig. 4 is a block diagram of a structure which is an embodiment of the invention;
Fig. 5 shows schematically the operation of cutting power to a circuit portion of the structure of Fig. 4;
Fig. 6 shows a first application of the structure of Fig. 4, as a multi-band low IF receiver;
Fig. 7 shows a second application of the structure of Fig. 4, as an I/Q demodulation receiver;
Fig. 8 shows a third application of the structure of Fig. 4 as a polarization diversity receiver.

### Detailed Description of the embodiments

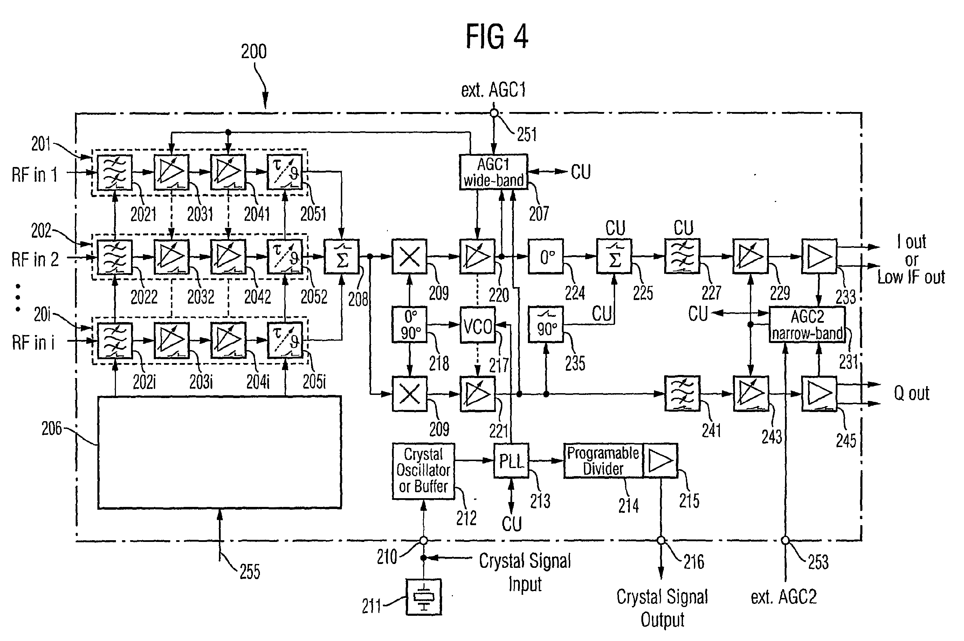

Referring firstly to Fig. 4, an embodiment of the invention is shown which is a RF signal decoder integrated circuit 200. The integrated circuit is to be used in combination with a digital base band demodulator processing unit (not shown) which may be of the form 13, 113 shown in Fig. 2 or Fig. 3. The integrated circuit 200 and the base-band demodulator are to be provided in a mobile device, which also comprises one or more antennas.

The integrated circuit 200 has a number *i* of input stages 201, 202, ..., 201*i*. Each of the input stages receives a respective one of *i* RF input signals marked as RF_{in1,} RFᵢₙ₂, ..., RF_{in*i*} (which may for example be derived from different ones of the respective antennas; other possibilities are described below). Each of the signal reception paths 201, 202, ..., 20*i* includes a respective filter 2021, 2022, ..., 202*i*, a respective pair of variable amplifiers 2031, 2032, ..., 203*i* and 2041, 2042, ..., 204*i*, and a respective adjustable phase and delay adjustment unit 2051, 2052, ..., 205*i*. The phase is indicated as ϑ and the delay as τ.

The integrated circuit 200 further includes a control unit (CU) 206, which controls the filters 2021, 2022, ..., 202*i* and the phase and delay adjustment units 2051, 2052, ..., 205*i*. The variable amplifiers 2031, 2032, ..., 203*i* and 2041, 2042, ..., 204*i* are controlled, based on a control signal derived from an first automatic gain control (AGC) unit 207, or from an external AGC1 251.

The function of the filters 2021, 2022, ..., 202*i* (which do not have analogues in the conventional devices described above) is to filter out all signals which are not mobile TV signals and in particular any RF signals generated by the mobile device itself as part of its other functions. For example, the filter may be set to remove GSM or CDMA signals. The reason for removing these components is that, almost inevitably, they tend to be a large component of the RF signals received by the antennas, and, if not removed, could overwhelm the mobile TV signals which the processing unit 200 is designed to obtain. The control unit 206 may optionally be designed to vary the frequency removed by the filters 2021, 2022, ..., 202*i* based on a knowledge of what frequency signals are being generated by the mobile device at any time.

Although the filters 2021, 2022, ..., 202*i* thus provide a useful filtering, it is envisaged that they may not be adequate to remove the whole of the RF signals which are due to signals emitted by the mobile device. For this reason, additional filters (not shown) may be provided outside the processing unit 200, and between the processing unit 200 and respective ones of the antennas.

The phase adjustment units 2051, 2052, ..., 205*i* are provided to adjust the phases and delays of the components before a summation by a summation unit 208. For example, considering a case in which there are two antennas, so that only two of the input stages are in use, and if it happens to be the case that the RF signals on the two antennas happen to be in anti-phase at the frequency which it is desired to extract, then the control unit 206 may be operative to control the corresponding phase and delay variation units so as to ensure that the two corresponding inputs to the summation unit 208 are substantially in phase. The control unit 206 may control these phases based on measurements it makes itself, or, more preferably based on control signals which it receives from off-chip (e.g. from the base-band demodulator unit) via a bus 255, as described in more detail below.

The outputs of the phase variation units 2051, 2052, ..., 205*i* are added by the summation unit 208, which transmits its output to two multiplier units 209.

The integrated circuit includes a pin 210 which receives either an externally generated oscillating signal (crystal signal input), or is connected to a crystal 211. The pin 210 is connected to a unit 212, which outputs an oscillating signal to a phase locked loop (PLL) unit 213, which receives a control signal from the CU 206.

In the case that the pin 210 is receiving an externally generated crystal signal input, the unit 212 acts simply as a buffer. Conversely, in the case, that the pin 210 is connected to a crystal 211, the unit 212 acts as a crystal oscillator, so that the oscillating signal is generated within the integrated circuit 200. In this case only, the oscillating signal should be transmitted out of the integrated circuit 200 to the base-band demodulator unit (not shown) so that it can be used to co-ordinate the timing of the base band demodulator, and this is done using components such as a programmable divider 214 and amplifier 215, leading to an output pin 216.

In either case an output of the PLL unit 213 is transmitted to a VCO 217, and from there to a unit 218 which uses it to generate two signals with the same frequency and a phase difference of 90°. These two signals are multiplied respectively with the outputs of the summation unit 208 by the multiplier units 209. The results are fed to respective variable amplifiers 220, 221. The amplification factor of the variable amplifiers 220, 221 are controlled using the output of the automatic gain control unit 207.

The output of the variable amplifier 220 is transmitted (though a 0° delay unit 224) to a summation device 225. The result is fed to a variable filter unit 227.

The units 225, 227 and 229 are all controlled based on control signals (not shown) generated by the control unit 206. From the unit 229 the signals pass to a variable amplifier 229, which is controlled based on a second gain control signal from a second AGC unit 231, and finally to an output amplifier 233.

In the case that the integrated circuit is used to perform the low IF demodulation, the output of the variable amplifier 221 is transmitted to a unit 235 which introduces a 90 delay phase difference to it relative to the output of the unit 221, and passes it to the summation unit 225. As may be seen by comparing Fig. 4 and Fig. 2(b), the configuration of components 213, 217, 218, 209, 220, 221, 224, 235, 225, 227, 229 of Fig. 4 corresponds essentially to the configuration of components 17, 19, 21, 23, 25, 27, 29, 31, 33, 35, 37 of Fig. 2(b), and thus performs a low IF demodulation of the combined RF signal output from the summation unit 208.

Conversely, in the case that the integrated circuit it used to perform the I/Q demodulation, the unit 235 is turned off, and the output of the variable amplifier 221 is instead transmitted to a variable filter 241, from there to a variable amplifier 243, and finally to an output amplifier 245. As may be seen by comparing Fig. 4 and Fig. 3(a), the configuration of components 213, 217, 218, 209, 220, 221, 224, 225, 227, 229, 241, 243, 245 of Fig. 4 corresponds to components 117, 119, 121, 123, 125, 151, 153, 155, 157, 159, 161 of Fig. 3(a), and thus performs an I/Q demodulation of the combined RF signal output from the summation unit 208.

As noted above, there are two independent forms of automatic gain control. A first form of automatic gain control is performed by the automatic gain control (AGC) unit 207. A second form of automatic gain control is performed by the automatic gain control (AGC) unit 231. Either or both of these units may operate in one of several ways.

Firstly, either or both of the AGC units 207, 231 may be directly controlled by the control unit 206. The control unit 206 itself may operate based on signals received from outside, e.g. from the digital processor unit via a bus 255 such as an I²C bus or 3-wire bus. This approach may allow the control unit 206 to be programmed to set AGC thresholds which optimise the balance between

RF and base-band AGC.

Secondly, either or both of the AGC units 207, 231 may be controlled by an external signal generated by the base-band demodulator unit (not shown), input to the processing unit 200 through the pins 251, 253.

Thirdly, either or both of the AGC units 207, 231 may operate based on a measurement made by the units themselves with a level detector. For example, as shown in Fig. 4, the AGC control unit 207 can operate based on the outputs of the units 220, 221. The AGC control unit 231 can operate based on the outputs of the units 233, 245. The control unit 206 may determine which of these techniques the AGC control units 207, 231 use.

The two forms of automatic gain control have different functions. The AGC unit 207 is "broad-band"; that is, it controls units which are processing the whole range of frequencies input from the antennas (except those removed by the filters 2021, 2022, ...202*i*), whereas the AGC unit 231 is "narrow-band", that is it controls only units which are processing the frequencies of particular interest after base-band filters 227, 241. Thus, the role of the unit 231 is analogous to the units 13, 113 of the known devices, causing a gain which is determined by the frequency components selected and output by the processing unit 200. The AGC unit 207, by contrast, is based on all the frequency components passing along the input stages (input paths) 201, 202, ..., 20*i*, and thus is able to ensure that the electronic components in the input stages 201, 202, ..., 20*i* operate in their linear range (or in a range with another desired linearity level). Thus, even if the signals received from the antennas contain components which are much larger than the selected frequency components sensed by the AGC unit 231, they are not allowed to overwhelm the components in the input stages 201, 202, ..., 20*i*.

The take over point of the AGC unit 207 will be selected to be as low as possible, such that the signal to noise ratio (SNR) is acceptable (e.g. it may be -70dBm). Since all the RF stages of the input stages 201, 202, ..., 20*i* are working with relatively low levels, their linearity may be poor. A low linearity design needs much less power than one with high linearity. Thus, the present arrangement provides a clear power saving.

Either or both of the AGC units 207, 231 may be analogue or digital. In the case of a digital implementation, the AGC level may be output as a digital word. The value may be transmitted from the integrated circuit 200 as a radio signal strength indicator (RSSI), which is of use to the base-band demodulator unit.

The control unit 206 controls whether the unit 235 is turned on, or alternatively whether the set of units 241, 243, 245 is turned on. Thus, the control unit 206 determines which of the operations is performed.

The control unit 206 preferably has the capability to turn off other portions of the integrated circuit 200 selectively too, in order to reduce the power consumption of the integrated circuit 200. For example, in the case that the number of antennas to which the mobile device is attached is less than the number *i* of signal input stages, then the control unit 206 is operative to turn off the redundant signal paths. Furthermore, in the case described above in which mobile TV data is not broadcast during all time periods, but only spaced apart by intervals during which mobile TV data is not broadcast, the control unit 206 is operative to shut down (i.e. put into a "sleep mode") one or more portions of the circuit during the intervals.

Alternatively or additionally, the control unit 206 preferably has the capability to modify the power consumption of certain of the components, such as one or more components of one or more of the input stages 201, 202, ..., 20*i*. For many designs of components this can be done simply by the control unit 206 applying a control signal to them. Thus, the control signal determines whether they operate either with a high degree of linearity (high current leading to high power consumption), or alternatively with a relatively lower degree of linearity and a correspondingly lower power consumption. The first of these alternatives is selected in an environment in which the power consumption of the mobile device is less significant than TV quality (e.g. when the mobile device is able to draw power from an external power supply, such as an electrical power supply in a motor car), while the second alternative is preferred in a situation in which it is acceptable to achieve a lower TV quality provided the power consumption is reduced.

As noted above, one mechanism by which the control unit 206 provides power saving modes is to switch off portions of the circuitry when it is not required. The control unit may perform this operation using the information sent through the I²C or 3 wire bus.

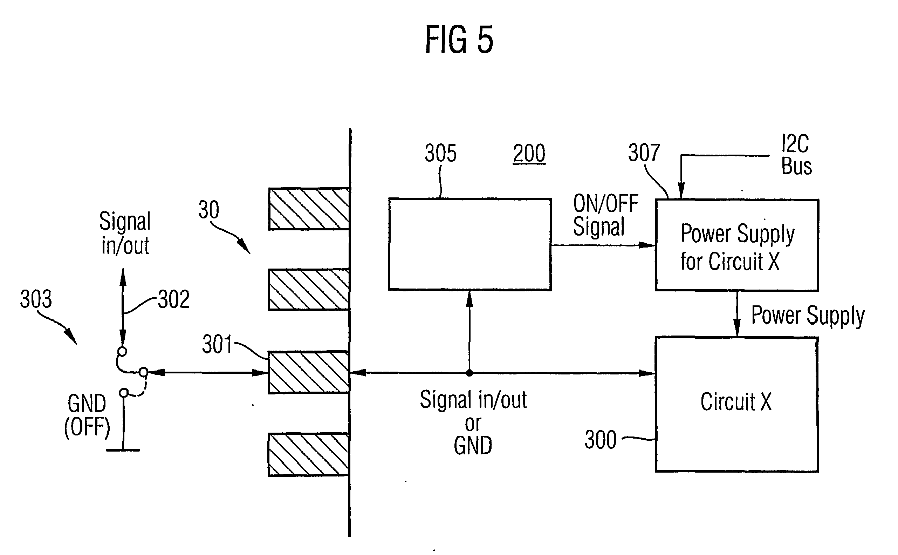

Alternatively, this may be implemented using a hardware switch which may switch off part(s) of the circuit which are known not to be used for the desired design and thus will be kept constantly off. Fig. 5 illustrates how this may be implemented. Fig. 5 shows part of the integrated circuit 200, and a few of its pins 30. The portion of the processing unit 200 which is to be switched off is indicated in Fig. 5 as "circuit X" 300. The circuit is provided with a connection to an IC pin 301, which is connected to a switch 303. The switch 303 may connect the pin 301 selectively to a ground GND or to a lead 302 through which a signal may be input to or output from the circuit X 300. The circuit X 300 is designed to be such as to be completely turned off when connected to ground via the pin 301. Designing the circuit 300 to be controllable in this way is relatively straightforward. The switch 303 is preferably fixed in one configuration during the construction of the device and is not switchable to the other position during the operation of the device. It may for example, be a "0 Ohm" resistor formed by soldering, and which either makes a connection to the ground, or to the signal in/out line.

The pin 301 is also electrically connected to a unit 305 which contains a buffer and a detector. In the case the detector detects that the pin 301 is connected to the ground, the buffer stores an OFF signal. In the case that the detector detects that the pin 301 is not connected to ground, the buffer stores an ON signal. In either case, the signal in the buffer is transmitted to a circuit 307 which is the power supply for circuit X. The circuit 307 is arranged to turn off whenever it receives the OFF signal from unit 305, and also whenever it receives an off signal via the I2C bus. Thus, when circuit X is turned off, the circuit 307 is also turned off.

The embodiment also provides high sensitivity. One method of doing this is that the amplifiers shown in Fig. 4 are preferably high quality components, having a low noise figure.

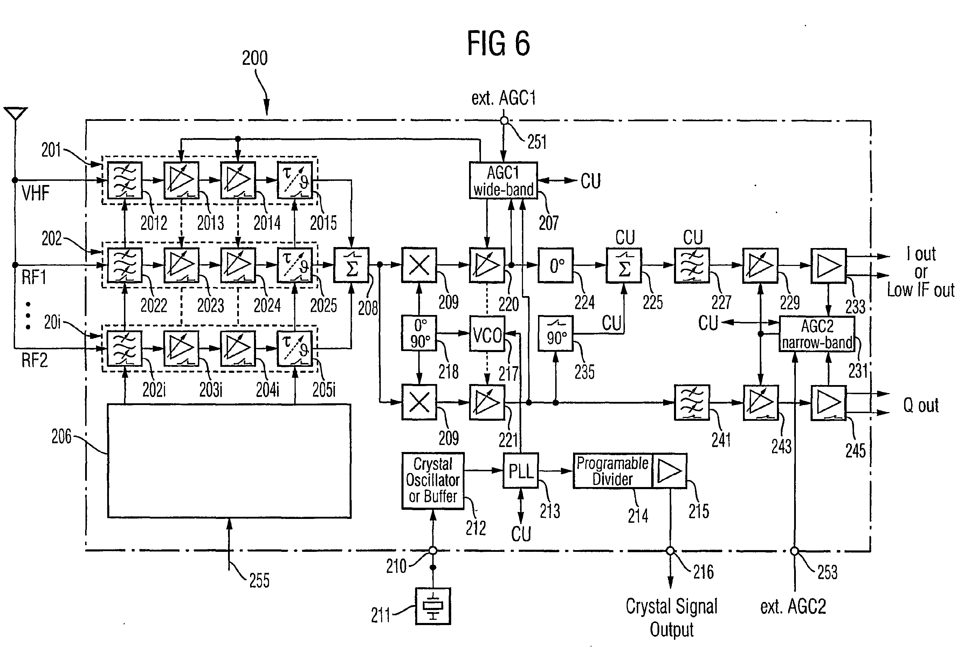

Another way in which the embodiment makes it possible to have high sensitivity, is that the total RF bandwidth may be divided into different bands (ranges), which are input to different ones of the input stages 201, 202, ..., 20i. The different RF bands may be selected to minimise the noise figure. One such possibility is illustrated in Fig. 6, in which the processing unit 200 is used with three RF bands (VHF, UHF1 and UHF2) which are input to different ones of the input stages.

To obtain low IF demodulation, the unit 235 is turned on, and the units 241, 243, 245 are turned off, so that a low IF signal is generated. In this case, the crystal 211 is being used, so that the crystal signal output from the unit 216 is transmitted to the digital processing unit (base-band demodulator).

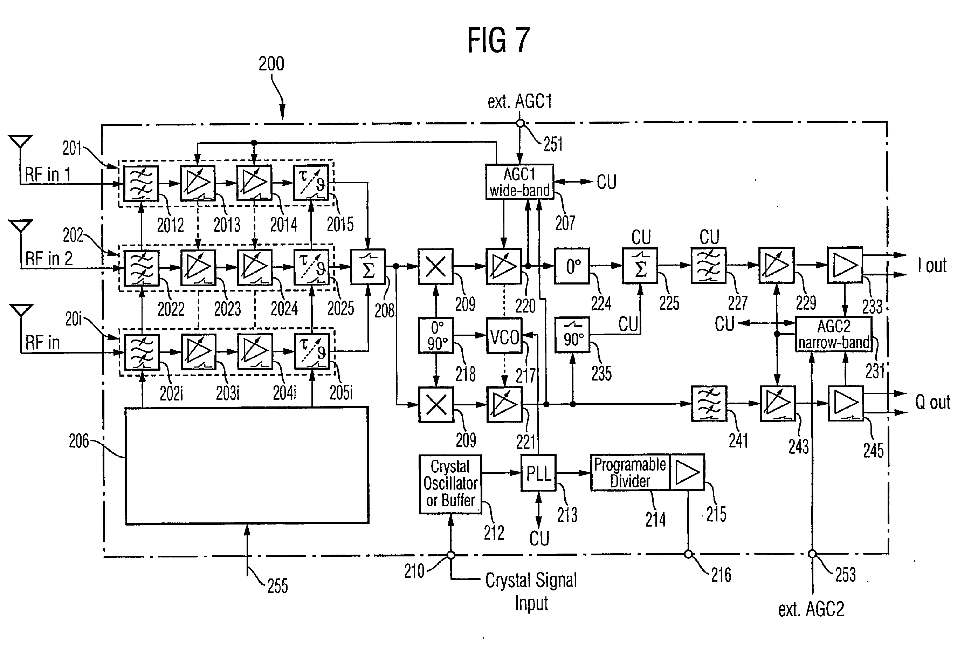

Another of the applications of the embodiment is for the multiple input stages 201, 202, ..., 20*i* to be connected to different, spaced apart antennas or an antenna array. Different ones of the antennas receive the mobile TV RF signal along different paths, and the multipath reception makes it possible to get rid of echoes and signal degradations. This is known as a MIMO (multiple input multiple output) receiver, exploiting the properties of so-called space diversity. Every input stage receives a respective version of the same signal using a different respective antenna, and the results are independently amplified, delayed and/or phase-shifted under the control of the control unit 206. Fig. 7 shows the signals RF1, RF2, RF3 received from three respective ones of the antennas, but the invention is not limited in this respect, and there may be any number of antennas.

The gain, phase and/or delay are selected on each input stage depending on the channel conditions into order to provide optimal results, essentially by equalising the incoming signals. The signals thus processed are finally added by the unit 208. In this application of the embodiment, each of the signals RF1, RF2, RF3 includes the entire frequency range in which the mobile TV signals are transmitted. The algorithms to control the input stages are performed by the second digital processing unit (base band demodulator).

In the application illustrated in Fig. 7, in another independent contrast to the application shown in Fig. 6, the unit 235 is turned off, and the units 241, 243, 245 are turned on, so that the integrated circuit 200 performs I/Q demodulation, and transmits the results to the base band demodulator.

Another, unrelated, difference between the applications of Fig. 6 and Fig. 7 is that the crystal 211 is not employed, and instead the input 210 relies on the crystal signal input generated by the base band demodulator. Hence the components 214, 215 are not required, and may be turned off.

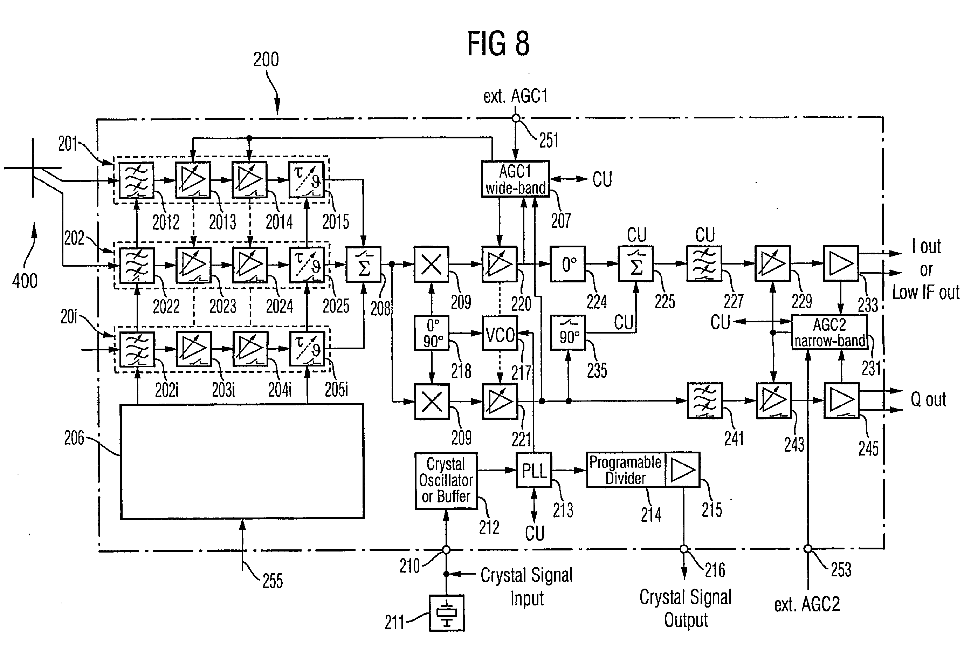

A third possible application of the embodiment of Fig. 4 is shown in Fig. 8. This application is motivated by the fact that conventionally mobile TV RF signals are polarized by the antenna which transmits them (e.g. horizontally, vertically, or circularly left or right polarized). It is well known that the strength of the received wave depends on the absolute position of the polarized wave, in relation to the extension direction of the antenna. The absolute position of the polarized wave may vary as the wave is propagated (e.g. by wave reflections against buildings), and of course the antenna itself may change position. The reception strength is highest when the extension direction of the antenna is parallel to the polarization direction; otherwise some of the strength is lost through polarization mismatch. In the application of the embodiment illustrated in Fig. 8 as an example, an antenna 400 is used which has arms extending in two orthogonal directions, so that different ones of the arms are particularly sensitive respectively to waves with two different polarizations (e.g. horizontal and vertical). The two arms of the antenna 400 are connected respectively to two outputs, which in turn are connected to two respective input stages. Thus the polarization losses are reduced. Note that any other kind of antenna configuration which detects the two different polarizations may be used instead of the antenna 400.

The PLL synthesiser 213 of the embodiment is preferably optimised to produce very low phase noise. This means that the system is suitable for OFDM signals, which, since OFDM uses multiple frequencies, have high frequency precision requirements. In order to improve the phase noise, the crystal reference frequency of the embodiment is higher than for conventional tuners (e.g. at least 16 MHz, or more preferably about 32 MHz, instead of 4 MHz). Thus, the phase comparator may work also at higher frequencies (e.g. 1 MHz), allowing broad-band PLL loop-filter bandwidths.

Although only a single embodiment of the invention has been shown, the invention is not limited in this respect, as will be clear to one skilled in this field. For example, although the integrated circuit 200 and the base band demodulator are illustrated above as separate integrated circuits, it would alternatively be possible to form them as a single unit.

## Claims

1. An integrated circuit for use in a mobile TV receiver, the integrated circuit having:
one or more input stages for receiving respective RF signals, including mobile TV signals,
a first signal processing path for performing low IF demodulation of the RF signals,
a second signal processing path for performing I/Q demodulation of the RF signals,
a control unit arranged to selectively connect the one or more input stages to the first signal processing path or to the second signal processing path, and
output means connected to the first and second signal processing paths,
whereby the control unit is arranged to determine whether the output means outputs signals which have been obtained from the one or more RF signals by IF demodulation or alternatively by I/Q demodulation.

2. An integrated circuit according to claim 1 in which the one or more input stages each include a filter for removing frequencies received which are not mobile TV signals and/or which are generated by the mobile TV receiver device.

3. An integrated circuit according to claim 1 or claim 2 in which the control unit is operative to disable at least one section of the integrated circuit, to reduce the power consumption of that section.

4. An integrated circuit according to claim 3 in which the control unit is operative to disable selectively the first or second processing paths.

5. An integrated circuit according to claim 3 or claim 4 in which the control unit are operative to disable one or more of the input stages.

6. An integrated circuit according to claim 3, claim 4 or claim 5 in which the control unit disables the section by setting a pin connected to the section to ground voltage.

7. An integrated circuit according to claim 6 in which the control unit, together with disabling the section, also turns off a circuit for delivering power to the section.

8. An integrated circuit according to any of claims 3 to 7 in which the control unit is operative based on a clock signal to turn at least one section of the integrated circuit on or off according to a timing present in the RF signal.

9. An integrated circuit according to any of claim 3 to 7 in which the control unit is operative to modify the operation at least one other component of the integrated circuit selectively between a first operation state with higher power consumption and a second operation state of lower power consumption.

10. An integrated circuit according to any preceding claim comprising at least two automatic gain control circuits, a first wideband automatic gain control circuit operative to control the gain of the input stages, and a second narrowband automatic gain control circuit operative to control the amplitude of the output of the output means.

11. An integrated circuit according to any preceding claim further including an phase-lock loop unit, a crystal oscillator, and oscillating signal transmission means for transmitting an oscillating signal generated using the crystal oscillator out of the integrated circuit.

12. An integrated circuit according to any of claims 1 to 11 further including an phase-lock loop unit and oscillating signal reception means for receiving a crystal oscillation signal input for driving the phase-lock loop unit.

13. An integrated circuit according to any of claims 1 to 11 further including a phase-lock loop unit, a crystal oscillator, oscillating signal reception means for receiving a crystal oscillation signal input for driving the phase-lock loop unit, and oscillating signal transmission means for transmitting an oscillating signal generated using the crystal oscillator out of the integrated circuit, and means for selecting whether the phase-lock loop unit is driven based on a crystal oscillation signal input

14. An integrated circuit according to claim 11 or claim 13 in which the crystal oscillator generates a signal in the range 1 to 60 MHz.

15. An integrated circuit according to claim 14 in which the crystal oscillator generates a signal of at least 16 MHz.

16. An integrated circuit according to any preceding claim in which the input stages each comprise a variable amplifier and/or a phase and time delay variation unit.

17. A mobile TV receiver device comprising:
an integrated circuit according to any preceding claim,
one or more antennas which generate one or more RF signals and transmit them to respective ones of the input stages of the integrated circuit,
a base-band processing unit which receives the output of the output means of the integrated circuit, and performs base band processing to produce TV signals; and
a screen which receives the TV signals and uses them to generate TV images.

18. A mobile TV receiver device according to claim 17 in which there are a plurality of antennas generating respective RF signals and transmitting them to respective ones of the input stages.

19. A mobile TV receiver device according to claim 17 which further includes:
means for partitioning the RF signals from at least one of the antennas into multiple components, the components being respective frequency ranges, and
means for transmitting the components to respective ones of the input stages.

20. A mobile TV receiver device according to claim 17 in which at least one of the antennas includes at least two portions for receiving radio signals with different polarizations, and which includes means for transmitting the received radio signals to different respective ones of the input stages.

21. A mobile TV receiver device according to any of claims 17 to 20 further comprising means for generating and transmitting RF signals of at least one transmission frequency, the receiver device including filter means for filtering out the transmission frequency from the RF signals received by the antennas.

22. A mobile device according to claim 21 in which the filter means includes at least one filter located within the integrated circuit on each of the input stages.

## Patentansprüche

1. Ein integrierter Schaltkreis zum Einsatz in einem mobilen Fernsehempfänger, wobei der integrierte Schaltkreis folgende Komponenten hat:
eine oder mehrere Eingangsstufen zum Empfang von entsprechenden HF-Signalen, einschließlich Signale für mobiles TV,
einen ersten Signalverarbeitungsweg zur Durchführung einer ZF-Demodulation im niederen Bandbereich (low IF) der HF-Signale,
einen zweiten Signalverarbeitungsweg zur Durchführung einer I/Q-Demodulation der HF-Signale,
eine Regeleinheit, die dafür vorgesehen ist, die eine oder mehrere Eingangsstufen wahlweise mit dem ersten Verarbeitungsweg oder mit dem zweiten Verarbeitungsweg zu verbinden, und
Ausgangsvorrichtungen, die mit dem ersten und zweiten Signalverarbeitungsweg verbunden sind,
wobei die Regeleinheit dafür vorgesehen ist, zu bestimmen, ob die Ausgangsvorrichtungen Signale ausgibt, die aus dem einen oder mehreren HF-Signalen durch ZF-Demodulation oder durch I/Q- Demodulation erhalten wurden.

2. Ein integrierter Schaltkreis entsprechend Anspruch 1, in dem die eine oder jede weitere Eingangsstufe mit einem Filter ausgestattet ist, um empfangene Frequenzen zu entfernen, die keine Signale für mobiles TV sind, und/oder die von dem mobilen Fernsehempfangsgerät erzeugt worden sind.

3. Ein integrierter Schaltkreis entsprechend Anspruch 1 oder Anspruch 2, in dem es eine Funktion der Regeleinheit ist, mindestens eine Sektion des integrierten Schaltkreises abzuschalten, um den Stromverbrauch dieser Sektion zu reduzieren.

4. Ein integrierter Schaltkreis entsprechend Anspruch 3, in dem es eine Funktion der Regeleinheit ist, wahlweise den ersten oder den zweiten Verarbeitungswege abzuschalten.

5. Ein integrierter Schaltkreis entsprechend Anspruch 3 oder Anspruch 4, in dem es eine Funktion der Regeleinheit ist, eine oder weitere der Eingangsstufen abzuschalten.

6. Ein integrierter Schaltkreis entsprechend Anspruch 3, Anspruch 4 oder Anspruch 5, in dem die Regeleinheit die Sektion **dadurch** abschaltet, dass sie einen Pin, der mit der Sektion verbunden ist, auf Erdspannung schaltet.

7. Ein integrierter Schaltkreis entsprechend Anspruch 6, in dem die Regeleinheit zugleich mit dem Abschalten der Sektion auch einen Schaltkreis abschaltet, der die Sektion mit Strom versorgt.

8. Ein integrierter Schaltkreis entsprechend jedem der Ansprüche 3 bis 7, in dem es eine Funktion der Regeleinheit ist, anhand eines Taktsignals mindestens eine Sektion des integrierten Schaltkreises entsprechend einer in den HF-Signalen enthaltenen Zeitvorgabe an- oder abzuschalten.

9. Ein integrierter Schaltkreis entsprechend jedem der Ansprüche 3 bis 7, in dem es eine Funktion der Regeleinheit ist, die Betriebsweise von mindestens einer anderen Komponente des integrierten Schaltkreises wahlweise zu wechseln zwischen einem ersten Betriebszustand mit höherem Stromverbrauch und einem zweiten Betriebszustand mit geringerem Stromverbrauch.

10. Ein integrierter Schaltkreis entsprechend jedem der vorangehenden Ansprüche, zu dem mindestens zwei automatische Verstärkungsregelungsschaltkreise gehören, ein erster breitbandiger automatischer Verstärkungsregelungsschaltkreis mit der Funktion, die Verstärkung der Eingangsstufen zu regeln, und ein zweiter schmalbandiger automatischer Verstärkungsregelungsschaltkreis mit der Funktion, die Amplitude der Ausgangssignale der Ausgangsvorrichtungen zu regeln.

11. Ein integrierter Schaltkreis entsprechend jedem der vorangehenden Ansprüche, des Weiteren bestehend aus einer phasengekoppelten Regelkreis-Einheit, einem Quartzoszillator und Schwingungssignal-Übertragungsvorrichtungen zur Übertragung eines Schwingungssignals, das durch Verwendung des Quartzoszillators aus dem integrierten Schaltkreis erzeugt wurde.

12. Ein integrierter Schaltkreis entsprechend jedem der Ansprüche 1 bis 11, des Weiteren bestehend aus einer phasengekoppelten Regelkreis-Einheit und Schwingungssignal-Empfangsvorrichtungen, um ein Quartzoszillator-Signal zu empfangen, das eingeleitet wird, um die phasengekoppelte Regelkreis-Einheit zu betreiben.

13. Ein integrierter Schaltkreis entsprechend jedem der Ansprüche 1 bis 11, des Weiteren bestehend aus einer phasengekoppelten Regelkreis-Einheit, einem Quartzoszillator, Schwingungssignal-Empfangsvorrichtungen, um ein Quartzoszillator-Signal zu empfangen, das eingeleitet wird, um die phasengekoppelte Regelkreis-Einheit zu betreiben und Schwingungssignal-Übertragungsvorrichtungen zur Übertragung eines Schwingungssignals, das durch Verwendung des Quartzoszillators aus dem integrierten Schaltkreis erzeugt wurde und Vorrichtungen um anzuwählen, ob die phasengekoppelte Regelkreis-Einheit anhand eines Quartzoszillator-Signaleingangs betrieben wird.

14. Ein integrierter Schaltkreis entsprechend Anspruch 11 oder Anspruch 13, in dem der Quartzoszillator ein Signal im Bereich 1 bis 60 MHz erzeugt.

15. Ein integrierter Schaltkreis entsprechend Anspruch 14, in dem der Quartzoszillator ein Signal mit mindestens 16 MHz erzeugt.

16. Ein integrierter Schaltkreis entsprechend jedem der vorangehenden Ansprüche, in dem jede der Eingangsstufen einen regelbaren Verstärker und/oder eine Phasen- und Zeitverzögerungsregeleinheit aufweist.

17. Ein mobiles Fernsehempfangsgerät, bestehend aus:
einem integrierten Schaltkreis entsprechend jedem der vorangehenden Ansprüche,
einer oder mehr Antennen, die ein oder mehr HF-Signale erzeugen und sie an die entsprechenden der Eingangsstufen des integrierten Schaltkreises übertragen,
eine Basisband-Verarbeitungseinheit, die die Ausgangssignale von den Ausgangsgangsvorrichtungen des integrierten Schaltkreises empfängt und eine Basisband-Verarbeitung durchführt, um Fernsehsignale zu erzeugen, und
ein Bildschirm, der die Fernsehsignale empfängt und sie nutzt, um Fernsehbilder zu erzeugen.

18. Ein mobiles Fernsehempfangsgeräts entsprechend Anspruch 17, in dem es eine Vielzahl von Antennen gibt, die jeweils eigene HF-Signale erzeugen und sie an die entsprechenden der Eingangsstufen übertragen.

19. Ein mobiles Fernsehempfangsgeräts entsprechend Anspruch 17, zu dem weiterhin gehören:
Vorrichtungen, um HF-Signale von mindestens einer der Antennen in mehrfache Komponenten zu teilen, wobei die Komponenten entsprechende Frequenzbereiche sind, und
Vorrichtungen, um die Komponenten zu der entsprechenden der Eingangsstufen zu übertragen.

20. Ein mobiles Fernsehempfangsgeräts entsprechend Anspruch 17, in dem mindestens eine der Antennen über mindestens zwei Teile verfügt, um Radiosignale mit verschiedenen Polarisationen zu empfangen, und die über Vorrichtungen verfügt, um die empfangenen Radiosignale an die unterschiedlichen entsprechenden der Eingangsstufen zu übertragen.

21. Ein mobiles Fernsehempfangsgerät entsprechend jedem der Ansprüche 17 bis 20, das des Weiteren besteht aus Vorrichtungen zur Erzeugung und Übertragung von HF-Signalen auf mindestens einer Übertragungsfrequenz, wobei zu dem Empfangsgerät Filtervorrichtungen gehört, um die Übertragungsfrequenzen aus den HF-Signalen, die über die Antennen empfangen wurden, herauszufiltern.

22. Ein mobiles Fernsehempfangsgeräts entsprechend Anspruch 21, in dem zu den Filtervorrichtungen mindestens ein Filter gehört, der sich innerhalb des integrierten Schaltkreises in jeder der Eingangsstufen befindet.

## Revendications

1. Circuit intégré destiné à être utilisé dans un récepteur de télévision mobile, le circuit intégré ayant :
un ou plusieurs étages d'entrée permettant de recevoir des signaux à fréquence radioélectrique respectifs, y compris des signaux de télévision mobile,
un premier trajet de traitement des signaux permettant d'effectuer une démodulation FI faible des signaux à fréquence radioélectrique,
un deuxième trajet de traitement des signaux permettant d'effectuer une démodulation I / Q des signaux à fréquence radioélectrique,
un module de commande permettant de connecter de manière sélective lesdits un ou plusieurs étages d'entrée sur le premier trajet de traitement des signaux ou sur le deuxième trajet de traitement des signaux, et
un moyen de sortie connecté sur le premier trajet de traitement des signaux et sur le deuxième trajet de traitement des signaux,
ce par quoi, le module de commande est arrangé pour déterminer si le moyen de sortie émet des signaux qui ont été obtenus à partir desdits un ou plusieurs signaux à fréquence radioélectrique par la démodulation FI ou comme autre possibilité par la démodulation I / Q.

2. Circuit intégré selon la revendication 1, dans lequel lesdits un ou plusieurs étages d'entrée comprennent chacun un filtre permettant d'éliminer des fréquences reçues qui ne sont pas des signaux de télévision mobile et / ou qui sont générées par le dispositif récepteur de télévision mobile.

3. Circuit intégré selon la revendication 1 ou la revendication 2, dans lequel le module de commande fonctionne pour désactiver au moins une section du circuit intégré, en vue de réduire la consommation de cette section.

4. Circuit intégré selon la revendication 3, dans lequel le module de commande fonctionne pour désactiver de manière sélective le premier trajet de traitement ou le deuxième trajet de traitement.

5. Circuit intégré selon la revendication 3 ou la revendication 4, dans lequel le module de commande fonctionne pour désactiver un ou plusieurs des étages d'entrée.

6. Circuit intégré selon la revendication 3, ou la revendication 4, ou la revendication 5, dans lequel le module de commande désactive la section en réglant sur la tension de terre un contact connecté sur la section.

7. Circuit intégré selon la revendication 6, dans lequel le module de commande, en plus de désactiver la section, met également hors tension un circuit destiné à acheminer de la puissance jusqu'à la section.

8. Circuit intégré selon l'une quelconque des revendications 3 à 7, dans lequel le module de commande fonctionne d'après un signal d'horloge pour mettre au moins une section du circuit intégré sous tension ou hors tension en fonction d'une temporisation présente dans le signal à fréquence radioélectrique.

9. Circuit intégré selon l'une quelconque des revendications 3 à 7, dans lequel le module de commande fonctionne pour modifier l'opération d'au moins une autre composante du circuit intégré de manière sélective entre un premier état d'opération avec une consommation supérieure et un deuxième état d'opération avec une consommation inférieure.

10. Circuit intégré selon l'une quelconque des revendications précédentes, comportant au moins deux circuits de commande automatique de gain, un premier circuit de commande automatique de gain de type large bande fonctionnant pour commander le gain des étages d'entrée, et un deuxième circuit de commande automatique de gain de type bande étroite fonctionnant pour commander l'amplitude de la sortie en provenance du moyen de sortie.

11. Circuit intégré selon l'une quelconque des revendications précédentes, comprenant par ailleurs un module à boucle à verrouillage de phase, un oscillateur à cristal, et un moyen de transmission des signaux oscillants permettant de transmettre un signal oscillant généré en utilisant l'oscillateur à cristal hors du circuit intégré.

12. Circuit intégré selon l'une quelconque des revendications 1 à 11, comprenant par ailleurs un module à boucle à verrouillage de phase et un moyen de réception de signaux oscillants permettant de recevoir une entrée de signal d'oscillation de cristal pour entraîner le module à boucle à verrouillage de phase.

13. Circuit intégré selon l'une quelconque des revendications 1 à 11, comprenant par ailleurs un module à boucle à verrouillage de phase, un oscillateur à cristal, un moyen de réception de signaux oscillants permettant de recevoir une entrée de signal d'oscillation de cristal pour entraîner le module à boucle à verrouillage de phase, et un moyen de transmission de signaux oscillants permettant de transmettre un signal oscillant généré en utilisant l'oscillateur à cristal hors du circuit intégré, et un moyen permettant de sélectionner si le module à boucle à verrouillage de phase est entraîné en fonction d'une entrée de signal d'oscillation de cristal.

14. Circuit intégré selon la revendication 11 ou la revendication 13, dans lequel l'oscillateur à cristal génère un signal de l'ordre de 1 à 60 MHz.

15. Circuit intégré selon la revendication 14, dans lequel l'oscillateur à cristal génère un signal de 16 MHz au moins.

16. Circuit intégré selon l'une quelconque des revendications précédentes, dans lequel les étages d'entrée comportent chacun un amplificateur variable et / ou un module de variation de retard et de phase.

17. Dispositif récepteur de télévision mobile comportant :
un circuit intégré selon l'une quelconque des revendications précédentes,
une ou plusieurs antennes qui génèrent un ou plusieurs signaux à fréquence radioélectrique et les transmettent à des étages d'entrée respectifs parmi les étages d'entrée du circuit intégré,
un module de traitement en bande de base qui reçoit la sortie en provenance du moyen de sortie du circuit intégré, et effectue un traitement en bande de base pour produire des signaux de télévision ; et
un écran qui reçoit les signaux de télévision et les utilise pour générer des images de télévision.

18. Dispositif récepteur de télévision mobile selon la revendication 17, dans lequel il y a une pluralité d'antennes générant des signaux à fréquence radioélectrique respectifs et les transmettant à des étages d'entrée respectifs parmi les étages d'entrée.

19. Dispositif récepteur de télévision mobile selon la revendication 17, qui comprend par ailleurs :
un moyen permettant de segmenter les signaux à fréquence radioélectrique en provenance d'au moins une des antennes en composantes multiples, les composantes étant des bandes de fréquences respectives, et
un moyen permettant de transmettre les composantes à des étages d'entrée respectifs parmi les étages d'entrée.

20. Dispositif récepteur de télévision mobile selon la revendication 17, dans lequel au moins une des antennes comprend au moins deux portions permettant de recevoir des signaux radio ayant différentes polarisations, et qui comprend un moyen permettant de transmettre les signaux radio reçus à différents étages d'entrée respectifs parmi les étages d'entrée.

21. Dispositif récepteur de télévision mobile selon l'une quelconque des revendications 17 à 20, comportant par ailleurs un moyen permettant de générer et de transmettre des signaux à fréquence radioélectrique d'au moins une fréquence de transmission, le dispositif récepteur comprenant des moyens de filtrage permettant d'éliminer par filtrage la fréquence de transmission provenant des signaux à fréquence radioélectrique reçus par les antennes.

22. Dispositif mobile selon la revendication 21, dans lequel le moyen de filtrage comprend au moins un filtre situé à l'intérieur du circuit intégré sur chacun des étages d'entrée.
